(19) Europäisches Patentamt

European Patent Office

Office européen des brevets

(11) **EP 1 079 415 A1**

(12) **EUROPEAN PATENT APPLICATION**

(43) Date of publication:
28.02.2001 Bulletin 2001/09

(51) Int. Cl.⁷: $H01J\ 37/32$, $G01B\ 11/06$, $H01L\ 21/00$

(21) Application number: 00117642.9

(22) Date of filing: 16.08.2000

(84) Designated Contracting States:
AT BE CH CY DE DK ES FI FR GB GR IE IT LI LU
MC NL PT SE
Designated Extension States:
AL LT LV MK RO SI

(30) Priority: 24.08.1999 US 379753

(71) Applicant:
Applied Materials, Inc.
Santa Clara, California 95054 (US)

(72) Inventor: Grimbergen, Michael N.
Redwood City, California 94065 (US)

(74) Representative:
Kirschner, Klaus Dieter, Dipl.-Phys.
Schneiders & Behrendt
Rechtsanwälte - Patentanwälte
Sollner Strasse 38
81479 München (DE)

(54) **Substrate (plasma) processing taking account of optical instabilities**

(57)     Plasma substrate (20) processing apparatus with radiation source (58). Detectors (62,63) detect radiation (62) from the chamber and radiation (63) from the source (58). Signal analyzer (130) normalyzes the radiations and applies a correction factor to the sample signal. Also the plasma can be used for both radiations. For reducing signal fluctuations and to improve the signal to noise ratio. The power level of the radiation source (58) is regulated or an EO or AO modulator is used. For end point detection and etch stop.

Fig. 1

EP 1 079 415 A1

**Description**

The present invention relates to monitoring of a substrate fabrication process.

In the fabrication of electronic devices, semiconductor, dielectric and conductor materials, such as for example, polysilicon, silicon dioxide, and metal containing layers, are deposited on a substrate and etched to form features such as patterns of gates, vias, contact holes and interconnect lines. These features are typically formed by chemical vapor deposition (CVD), physical vapor deposition (PVD), oxidation and etching processes. For example, in a typical etching process, a patterned mask of photoresist or oxide hard mask is formed on a substrate by photolithographic methods and exposed portions of the substrate are etched by a plasma. In a typical CVD process, a plasma of a gas is decomposed to deposit a layer on the substrate. In PVD processes, a target facing the substrate is sputtered to deposit the target material onto the substrate.

In such processes, it is often necessary to monitor events within the process chamber, including process conditions such as pressure, temperature, deposition on chamber sidewalls, and especially substrate characteristics such as etch depth, layer thickness and composition. For example, in deposition processes, it may be desirable to change process conditions to change the nature of the film being deposited on the substrate or to stop deposition after a desired film thickness has been obtained. In etching processes, it may be desirable to stop etching of a particular layer (for example, a gate oxide layer) at a specified thickness. Techniques to monitor substrate characteristics involve providing radiation in the process chamber to interact with the substrate and/or a plasma and detecting the radiation emanating from the chamber. Chamber conditions such as the thickness of deposits formed on chamber walls, can also be monitored by directing the radiation onto the chamber wall and measuring the reflected radiation.

Examples of these monitoring techniques include interferometry and ellipsometry. In interferometry, a light beam directed onto a layer on a substrate is partially reflected from the surface of the layer, and partially transmitted through the layer and reflected by one or more underlayers. Constructive and destructive interference of the multiple reflections give rise to an interference pattern which undergoes periodic maxima and minima depending upon the path length of the radiation through the thickness of the layer being processed on the substrate. Before processing of the substrate, an initial thickness of the layer is assumed or measured. During processing, the observed periodic maxima and minima of a measured interference pattern are directly correlated to a calculated reduction in thickness of the layer (which would result in a changing pathlength of the radiation transmitted through the layer being processed) to estimate an endpoint of the process. Examples of interferometric apparatus and techniques are described in U.S. Patent Nos. 4,776,695, 5,691,540, 4,680,084, 4,840,487, and 5,087,121 — all of which are incorporated herein by reference. As another example, in ellipsometry, a polarized light beam is reflected from a layer being processed on a substrate and analyzed to determine changes in the phase and magnitude of the reflected light beam that occur as the layer is being processed, as for example as disclosed in U.S. Patent Nos. 3,874,797 and 3,824,017, both of which are incorporated herein by reference.

In the processing of sub-micron sized features, the magnitude of the radiation signal used to monitor the processing of features on the substrate becomes proportionately smaller as the size of the features becomes smaller. As a result, the signal-to-noise ratio of the monitored signal is significantly reduced and any fluctuations of the light sources from which the radiation signals originate, play a larger role in reducing the radiation signal being monitored. In prior art processes, the small levels of the source fluctuations were not a significant problem because process-induced changes in the reflected radiation had a relatively large magnitude. However, as the size of the etched features or the thickness of the etched and deposited layers becomes smaller, the magnitude of the reflected radiation change is also smaller, and previously undetectable signal fluctuations now reduce the signal to noise ratio to unacceptably low levels.

In addition, radiation generated from the plasma may also interfere with the radiation signal that is being monitored during the process, which further reduces the signal to noise ratio of the monitored radiation signal. When an external radiation source is used as the source of the radiation, the background radiation from the plasma interferes with, or dominates, the radiation measurements that are being monitored, especially where the radiation being measured has wavelengths similar to the radiation emitted by the plasma. This overlap of wavelengths occurs, for example, where a mercury lamp is used as the radiation source, and a silicon dioxide or other dielectric layer is being etched with a plasma containing fluorine or argon. In these cases, it is desirable to reduce the effect of the fluctuations of background and the source radiation.

Thus, it is desirable to accurately monitor radiation signals during the plasma processing of a substrate in a process chamber. It is further desirable to reduce signal fluctuations that occur during processing and improve the signal-to-noise ratio of the radiation measurements. It is also desirable to have a process chamber and monitoring system that may be easily adapted to existing apparatus.

These needs are satisfied by the present invention as claimed in the independant claims.

In one aspect, the invention provides a substrate processing apparatus comprising a process chamber, a radiation source capable of providing radiation in the chamber; one or more detectors to detect a first radiation from the chamber and a second radiation from the radiation source; and a signal analyzer to normalize a property of the first radiation relative to a property of the second radiation.

In another aspect, a method for monitoring processing of a substrate in a chamber comprises the steps of providing radiation in the chamber, detecting the radiation after it interacts with the substrate being processed, and generating a sample signal detecting a reference radiation that does not interact with the substrate and generating an reference signal; and normalizing the sample signal relative to the reference signal.

In a further aspect, a substrate processing apparatus comprises a chamber capable of processing a substrate. The chamber comprises a radiation source. A detector is provided to detect a reflected radiation from the chamber and to generate a sample signal. A signal analyzer is adapted to receive the sample signal and to determine a corrected sample signal, $X_{nt}$, using the expression $X_{nt} = X_t / \{Y_0 + C(Y_t - Y_0)\}$, where C is the correction factor, $Y_0$ is the reference signal at time 0, $X_t$ is the sample signal at time t, and $Y_t$ is the reference signal at time t.

In another aspect, a substrate processing apparatus comprises a chamber capable of processing a substrate. The chamber comprises a radiation source. A sample detector is provided to detect a reflected radiation from the chamber and to generate a sample signal. A reference detector is provided to detect a reference radiation from the radiation source and generate a reference signal and one or more first fibers are provided to transmit the reference radiation to the reference detector.

In yet another aspect, a substrate processing apparatus comprising a chamber capable of processing a substrate. The chamber comprises a radiation source that includes a plasma; a sample detector to detect a reflected radiation from a substrate in the chamber and generate a sample signal; a reference detector to detect a reference radiation from the plasma and generate a reference signal; and one or more first fibers to transmit the reference radiation to the reference detector.

In another aspect, a substrate processing apparatus comprises a chamber having a radiation source; a detector to detect a property of a radiation from a radiation source; and a feedback controller to regulate a power level of the radiation source in relation to the detected property of the radiation.

In another aspect, a substrate processing apparatus comprises a chamber; a radiation source; a detector to detect a property of a radiation from a radiation source and generate a reference signal; and a radiation modulator in a path of a radiation being transmitted from the radiation source to the chamber, whereby the radiation modulator may receive a signal from the radiation source and control a property of the radiation in relation to the reference signal.

In a further another aspect, a method for monitoring processing of a substrate in a chamber comprises the steps of providing radiation in the chamber; detecting a reference radiation that does not interact with the substrate and generating an reference signal; and controlling a property of the radiation in relation to the reference signal.

According to an aspect of the invention, there is provided a substrate processing apparatus comprising (a) a chamber comprising a radiation source; (b) one or more detectors to detect a first radiation from the chamber, and a second radiation from the radiation source; and (c) a signal analyzer to normalize a property of the first radiation relative to a property of the second radiation.

According to a preferred aspect of the invention, there is provided an apparatus wherein the detectors are adapted to detect the same property of the first and second radiation, the property comprising one or more of an intensity, phase or wavelength.

According to a preferred aspect of the invention, there is provided an wherein the detectors are adapted to detect the first and second radiation to determine an endpoint of the process.

According to a preferred aspect of the invention, there is provided an apparatus comprising a first detector to detect a first radiation that is reflected in the chamber and generate a sample signal; and a second detector to detect a second radiation from the radiation source and generate a reference signal.

According to a preferred aspect of the invention, there is provided an apparatus wherein the signal analyzer normalizes the reference and sample signals relative to one another to determine a normalized signal.

According to a preferred aspect of the invention, there is provided an apparatus wherein the signal analyzer normalizes the reference and sample signals by determining a ratio of the signals.

According to a preferred aspect of the invention, there is provided an apparatus wherein the signal analyzer is adapted to determine a corrected sample signal by applying a correction factor to the normalized signal.

According to a preferred aspect of the invention, there is provided an apparatus wherein the signal analyzer determines a corrected sample signal, $X_{nt}$, using the expression $X_{nt} = X_t / \{Y_0 + C(Y_t - Y_0)\}$, where C is the correction factor, $Y_0$ is the reference signal at time 0, $X_t$ is the sample signal at time t, and $Y_t$ is the reference signal at time t.

According to a preferred aspect of the invention, there is provided an apparatus wherein the signal analyzer determines the correction factor using the equation $C = \{Y_0(X_t - X_1)\}/\{X_1(Y_t - Y_0)\}$, where $X_1$ is the sample signal at time 1.

According to a preferred aspect of the invention, there is provided an apparatus wherein the signal analyzer determines the correction factor by the equation $C = X_0 / X_1$; where $X_0$ is the sample signal at time 0; and $X_1$ is the sample signal at time 1.

According to a preferred aspect of the invention, there is provided an apparatus further comprising a radiation pathway capable of transmitting the second radiation from the radiation source to the second detector.

According to a preferred aspect of the invention, there is provided an apparatus wherein the radiation pathway is in a radiation transmitting fiber.

According to a preferred aspect of the invention, there is provided an apparatus wherein the radiation transmitting fiber comprises an optical fiber.

According to a preferred aspect of the invention, there is provided an apparatus wherein the radiation source comprises a lamp, light emitting diode, laser, or a radiation emission from a plasma in the chamber.

According to an aspect of the invention, there is provided a method for monitoring processing of a substrate in a chamber, the method comprising the steps of (a) providing radiation in the chamber, detecting the radiation after it interacts with the substrate being processed, and generating a sample signal; (b) detecting a reference radiation that does not interact with the substrate and generating an reference signal; and (c) normalizing the sample signal relative to the reference signal.

According to a preferred aspect of the invention, there is provided a method wherein step (c) comprises the step of determining a ratio of the reference signal and the sample signal, or subtracting the reference signal from the sample signal.

According to a preferred aspect of the invention, there is provided a method further comprising the step of correcting for a background radiation by applying a correction factor to the sample signal to determine a corrected sample signal.

According to a preferred aspect of the invention, there is provided a method comprising the step of determining the corrected sample signal, $X_{nt}$, using the expression $X_{nt} = X_t / \{Y_0 + C(Y_t - Y_0)\}$; wherein C is the correction factor, $Y_0$ is the reference signal at time 0, $X_t$ is the sample signal at time t, and $Y_t$ is the reference signal at time t.

According to a preferred aspect of the invention, there is provided a method comprising the step of calculating the correction factor using the equation $C = \{Y_0(X_t - X_1)\}/\{X_1(Y_t - Y_0)\}$; wherein $X_1$ is the sample signal at time 1.

According to a preferred aspect of the invention, there is provided a method comprising the step of calculating the correction factor using the equation $C = X_0 / X_1$; wherein $X_0$ is the sample signal at time 0; and $X_1$ is the sample signal at time 1.

According to a preferred aspect of the invention, there is provided a method wherein step (b) comprises detecting radiation reflected from the substrate being processed in the chamber.

According to a preferred aspect of the invention, there is provided a method further comprising the step of detecting the reference radiation by transmitting radiation from a radiation source directly to a detector.

According to an aspect of the invention, there is provided a substrate processing apparatus comprising: (a) a chamber capable of processing a substrate, the chamber comprising a radiation source; (b) a detector to detect a reflected radiation from the chamber and generate a sample signal; and (c) a signal analyzer adapted to receive the sample signal and determine a corrected sample signal, $X_{nt}$, using the expression $X_{nt} = X_t / \{Y_0 + C(Y_t - Y_0)\}$, where C is the correction factor, $Y_0$ is the reference signal at time 0, $X_t$ is the sample signal at time t, and $Y_t$ is the reference signal at time t.

According to a preferred aspect of the invention, there is provided an apparatus wherein the signal analyzer determines the correction factor using the equation $C = \{Y_0(X_t - X_1)\}/\{X_1(Y_t - Y_0)\}$; where $X_1$ is the sample signal at time 1.

According to a preferred aspect of the invention, there is provided an apparatus wherein the signal analyzer determines the correction factor using the equation $C = X_0 / X_1$; where $X_0$ is the sample signal at time 0; and $X_1$ is the sample signal at time 1.

According to a preferred aspect of the invention, there is provided an apparatus wherein the detector is adapted to detect a radiation originating from the radiation source and generate a reference signal, and wherein the signal analyzer is adapted to receive the reference signal and determine a normalized signal from the sample and reference signals.

According to a preferred aspect of the invention, there is provided an apparatus wherein the signal analyzer determines the normalized signal by calculating a ratio of the sample and reference signals.

According to a preferred aspect of the invention, there is provided an apparatus further comprising a radiation pathway capable of transmitting radiation from the radiation source to the reference detector.

According to a preferred aspect of the invention, there is provided an apparatus wherein the radiation pathway is in one or more fibers.

According to an aspect of the invention, there is provided a substrate processing apparatus comprising: (a) a chamber capable of processing a substrate, the chamber comprising a radiation source; (b) sample detector to detect a reflected radiation from the chamber and generate a sample signal; (c) a reference detector to detect a reference radiation from the radiation source and generate a reference signal; and (d) one or more first fibers to transmit the reference radiation to the reference detector.

According to a preferred aspect of the invention, there is provided an apparatus further comprising second fibers to transmit radiation from the radiation source to the chamber.

According to a preferred aspect of the invention, there is provided an apparatus wherein the first and second fibers are arranged to receive radiation from one or more areas of the radiation source that have about the same size.

According to a preferred aspect of the invention, there is provided an apparatus wherein the areas are from the same region of the radiation source.

According to a preferred aspect of the invention, there is provided an apparatus wherein the first and second fibers are arranged to have substantially overlapping field of views.

According to a preferred aspect of the invention, there is provided an apparatus wherein the first fibers lead directly from the radiation source to the reference detector.

According to a preferred aspect of the invention, there is provided an apparatus further comprising a lens to focus the reference radiation from the radiation source onto the first fibers.

According to a preferred aspect of the invention, there is provided an apparatus further comprising a signal analyzer to receive the reference and sample signals and normalize one relative to the other, and optionally, to correct the sample signal for background radiation.

According to an aspect of the invention, there is provided a substrate processing apparatus comprising: (a) a chamber capable of processing a substrate, the chamber comprising a radiation source that includes a plasma; (b) a sample detector to detect a reflected radiation from a substrate in the chamber and generate a sample signal; (c) a reference detector to detect a reference radiation from the plasma and generate a reference signal; and (d) one or more first fibers to transmit the reference radiation to the reference detector.

According to a preferred aspect of the invention, there is provided an apparatus wherein the second fibers receive radiation from the side of the plasma, or from an angle of the plasma which is not above the substrate.

According to an aspect of the invention, there is provided a substrate processing apparatus comprising: (a) a chamber comprising a radiation source; (b) a detector to detect a property of a radiation from a radiation source; and (c) a feedback controller to regulate a power level of the radiation source in relation to the detected property of the radiation.

According to a preferred aspect of the invention, there is provided an apparatus wherein the feedback controller is adapted to control a power supply that powers the radiation source.

According to a preferred aspect of the invention, there is provided an apparatus wherein the feedback controller is adapted to maintain the property of the radiation at a constant level.

According to a preferred aspect of the invention, there is provided an apparatus wherein the detector is adapted to detect a property of the radiation comprising one or more of an intensity, phase or wavelength.

According to an aspect of the invention, there is provided a substrate processing apparatus comprising: (a) a chamber; (b) a radiation source; (c) a detector to detect a property of a radiation from a radiation source and generate a reference signal; and (d) a radiation modulator in a path of a radiation being transmitted from the radiation source to the chamber, whereby the radiation modulator may receive a signal from the radiation source and control a property of the radiation in relation to the reference signal.

According to a preferred aspect of the invention, there is provided an apparatus wherein the detector is adapted to detect a property of the radiation comprising one or more of an intensity, phase or wavelength.

According to a preferred aspect of the invention, there is provided an apparatus wherein the radiation modulator is adapted to regulate an intensity of the radiation.

According to a preferred aspect of the invention, there is provided an apparatus wherein the radiation modulator is adapted to maintain the intensity of the radiation at a constant level.

According to a preferred aspect of the invention, there is provided an apparatus wherein the radiation modulator comprises a shutter, mirror, or variable density screen.

According to a preferred aspect of the invention, there is provided an apparatus wherein the radiation modulator comprises a means for partially attenuating the radiation.

According to a preferred aspect of the invention, there is provided an apparatus wherein the radiation modulator comprises an electro-optical or acoustic-optical transducer.

According to a preferred aspect of the invention, there is provided an apparatus wherein the radiation is transmitted to the detector by one or more radiation transmitting fibers.

According to an aspect of the invention, there is provided a method for monitoring processing of a substrate in a chamber, the method comprising the steps of: (a) providing radiation in the chamber; (b) detecting a reference radiation that does not interact with the substrate and generating an reference signal; and (c) controlling a property of the radiation in relation to the reference signal.

According to a preferred aspect of the invention, there is provided a method wherein step (c) comprises controlling a power level applied to a power supply of a radiation source.

According to a preferred aspect of the invention, there is provided a method further comprising the steps of detecting the radiation after it interacts with the substrate being processed, and generating a sample signal and determining a ratio of the reference signal and the sample signal, or subtracting the reference signal from the sample signal.

According to a preferred aspect of the invention, there is provided a method further comprising the step of correcting for a background radiation by applying a correction factor to the sample signal to determine a corrected sample signal.

According to a preferred aspect of the invention, there is provided a method comprising the step of transmitting the reference radiation through a fiber.

The embodiments of the present invention will be better understood from the following drawings, description and appended claims, which illustrate examples of the invention. While the description and drawings below illustrate embodiments of the invention, it is to be understood that each of the features can be used in the invention in general, not merely in the context of the particular drawing, and the invention includes any combination of these features.

Figure 1
is a schematic sectional view of a substrate processing apparatus according to the principles of the present invention;

Figures 2a to 2d
are schematic diagrams showing different arrangements of fiber bundles for receiving source or reference radiation;

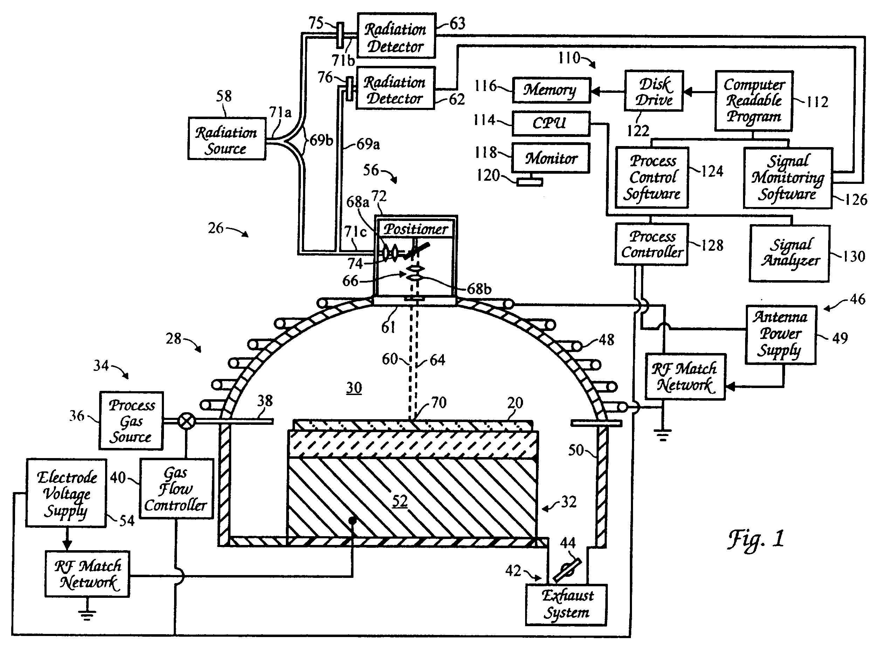

Figure 3
is a flowchart of a process for monitoring etching of a substrate in the apparatus of Figure 1;

Figure 4
is a graph of the intensities versus time of a sample signal (a), the corresponding reference signal (b), and the normalized sample signal after correcting for fluctuations in source and background radiation (c);

Figure 5
is an illustrative block diagram of a hierarchical structure of a process control software of a computer-readable program according to the present invention; and

Figures 6 and 7
are schematic diagrams of an apparatus suitable for compensating for source fluctuations by a feedback loop circuitry.

The present invention is useful for monitoring events in an apparatus via a radiation measuring technique such as for example, reflectance/absorbence, interferometry, ellipsometry and photoluminescence. The events are process characteristics that include for example, process conditions such as pressure, temperature, deposition on chamber sidewalls; and substrate properties such as etch depth, layer thickness, trench depth and composition. The invention is particularly useful for endpoint detection and reflectivity-based processes, such as interferometry, that are conducting during plasma etching or deposition processes. For example, a substrate 20 may be etched in the etching apparatus 26 that is illustrated in Figure 1, and the etching process being conducted on the substrate 20 may be monitored by the present invention. Typically, the substrate 20 comprises a support, such as a wafer of silicon or a compound semiconductor, or a dielectric such as silicon dioxide, and the substrate 20 may have thereon a plurality of layers, such as for example, include dielectric, semiconducting, and metal-containing conductor layers. Generally, the apparatus 26 comprises a process chamber 28 having a process zone 30 for processing the substrate 20 and a support 32 that supports the substrate 20. Process gas is introduced into the chamber 28 through a gas delivery system 34 comprising a process gas supply 36, gas outlets 38 located around the periphery of the substrate 20 (as shown) or in a showerhead mounted on the ceiling of the chamber (not shown), and a gas flow controller 40 adapted to control the flow rate of the process gas. Spent process gas and etchant byproducts are exhausted from the chamber 28 through an exhaust 42 comprising roughing and turbomolecular pumps (not shown) and a throttle valve 44 is used to control the pressure of process gas in the chamber 28. An energized gas or plasma is generated from the process gas by a plasma generator 46 that couples RF or microwave energy to the process gas in the process zone 30 of the chamber 28, such as for example, an inductor antenna 48 comprising one or more coils powered by an antenna power supply 49 that inductively couple RF energy to the chamber. In addition, a first process electrode 50 — such as an electrically grounded ceiling or sidewall of the chamber 28, and a second electrode 52 — such as an RF biased support 32 below the substrate 20, can be used to further energize the gas in the chamber 28. The first and second electrodes 50, 52 are electrically biased relative to one another by an RF voltage provided by an electrode voltage supply 54. The frequency of the RF voltage applied to the inductor antenna 48 and the electrodes 50, 52 is typically from about 50 KHz to about 60 MHz and more typically about 13.56 MHz.

The apparatus also comprises a radiation source 58 that may be outside or inside the chamber to provide a source of radiation in the chamber 28. The radiation source 58 may comprise, for example, an emission from a plasma generated inside the chamber 28, the plasma emission being generally multispectral, i.e., providing radiation having multiple wavelengths extending across a spectrum. The radiation source 58 may also be positioned outside the chamber 28 so that radiation 60 is passed from the source 58 through a window 61 and into the chamber 28. The radiation source 58 may provide radiation such as ultraviolet (UV), visible or infrared radiation; or may provide other types of radiation such as X-rays. In one version, the radiation source 58 provides radiation having only a predominant wavelength, such as a monochromatic light having primarily radiation at a single or a few wavelengths, for example, a He-Ne or Nd-YAG laser. Alternatively, the radiation source 58 may provide multiple wavelengths of radiation, such as polychromatic light, which may be selectively filtered to provide substantially only a single wavelength. Suitable radiation sources 58 for providing polychromatic light include Hg discharge lamps that generate a polychromatic spectrum of light having wavelengths in the range of from about 180 to about 600 nanometers, arc lamps such as xenon or Hg-Xe lamps and tungsten-halogen lamps; and light emitting diodes (LED).

During process monitoring, it has been discovered that instabilities of the properties or other characteristics of the radiation emitted from the radiation source 58 can significantly reduce the signal to noise ratio of the monitored or detected radiation. These instabilities may be in the form of changes in the intensity, wavelength or phase of the radiation. For example, UV lamps have been found to exhibit substantial intensity instabilities of emitted UV radiation during the time it takes to fully process a substrate. From a study of mercury arc lamps it has been further discovered that the intensity of these lamps may vary temporally as a function of time, spatially with different areas of the lamp emitting different intensities, or both temporally and spatially, and the temporal variations may also differ at differing wavelengths. The instabilities may include spikes, jumps and broadband noise. In a series of experiments, the intensity of low-pressure discharge mercury lamps was measured over several days using a UV-sensitive PMT detector with a bandpass filter. The lamp intensity was observed to oscillate intermittently over a duration of minutes, hours and even days with an amplitude of up to 5% and a period of 3 to 90 seconds. Similar instabilities can be observed for other sources such as arc lamps. The instabilities are not predictable, may occur for only a few seconds or a few hours and may result in significantly inaccurate measurements, especially when the feature being measured is thin or small. Thus it is important to correct the lamp instabilities in situ with processing of the substrate.

The system 56 further comprises a first radiation detector 62 which serves as a sample detector for detecting radiation 64 emanating from the chamber 28 and after the radiation is reflected from the chamber walls or substrate 20. A single radiation detector 62 may be used to detect both the reflected radiation as well as radiation originating directly from the radiation source 58, by for example, alternating inputs from the source 58 and process chamber 28. Alternatively, the system 56 may also comprise a plurality of detectors, including for example a second radiation detector 63 which serves as a reference detector for detecting radiation emitted from the radiation source 58. The detectors 62, 63 comprise a radiation sensor, such as a photovoltaic cell, photodiode, photomultiplier, or phototransistor, which provides an electrical output signal in response to a measured intensity of the sample radiation 64. The detector signal can comprise a change in the level of a current passing through an electrical component or a change in a voltage applied across an electrical component. The detector may comprise a photomultiplier (PMT), such as those commercially available from Hamamatsu, Japan.

The detectors 62, 63 may be coupled to the chamber 28 by one or more radiation transmitting fibers 69 or other equivalent means for transmitting radiation, such as a radiation conduit, that lead from the chamber 28 to the detectors 62, 63. This reduces noise from the external environment by providing an isolated radiation pathway along which the radiation is carried. The type of fiber 69 depends upon the radiation being transmitted therethrough, for example, an optical fiber is suitable for the transmission of UV or visible radiation. In one version, the fibers 69 comprise one or more sets or bundles of fibers, as shown in Figure 1, with for example, one fiber bundle 69a being used to transmit radiation emanating from the chamber 28 to a sample detector 62 that measures the radiation properties during processing of a substrate 20 in the chamber 28. Another bundle of fibers 69b is positioned so that one end 71a receives radiation directly from the radiation source 58, and the other two bifurcated ends 71b,c transmit the radiation to a reference detector 63 and to the chamber 28, respectively. This arrangement of fibers is suitable for transmitting radiation directly from the source 58 to the chamber and detectors to allow for correction of temporal variations in the properties of the radiation provided by the source, i.e., when a property of the radiation varies over a period of time.

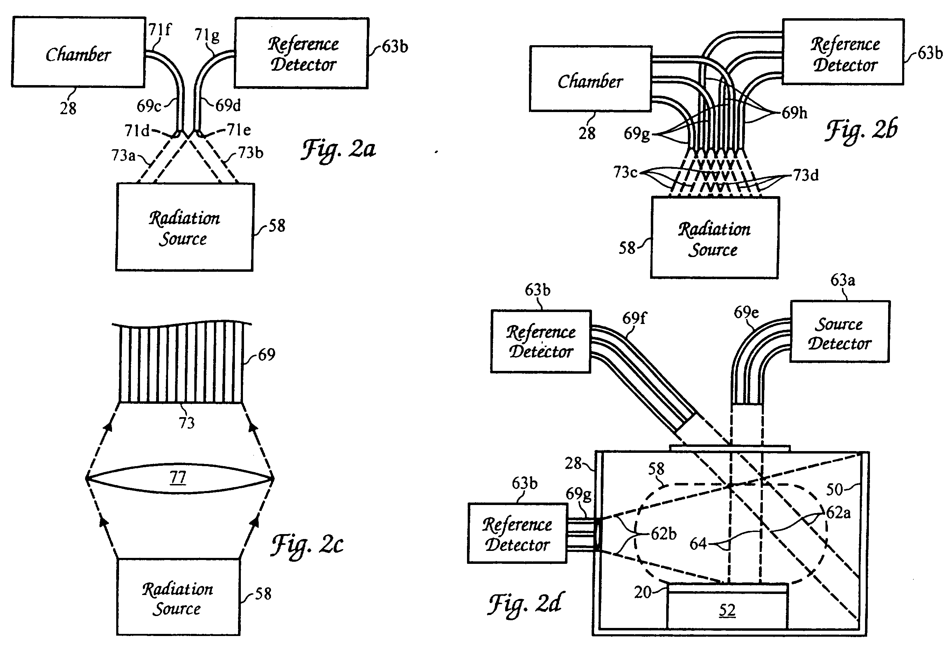

Effective use of ratio mode depends on a sampling method if light intensity varies spatially as well as temporally. Thus, when using a beam splitter or pick-off mirror, the area of the source 58 that is sampled for the reference detector 63 must correspond as closely as possible to that of the area of the source 58 that is sampled to serve as the radiation for the chamber 28b. For example, in the version shown in Figure 2a, a pair of fibers 69c,d are shown with their ends 71d,e provided adjacent to the radiation source 58 to receive radiation therefrom, and with their other ends 71f,g transmitting the radiation to the chamber 28 and the reference detector 63, respectively. Fiber sampling has an intrinsic advantage due to the small size of the fibers 69c,d. If the size of the fibers 69c,d is much larger than the area of the source 58 being sampled, then side-by-side fibers, one for the signal beam to the chamber 28 and one for the reference beam, may be used to sample the same area of the source 58 to provide good cancellation of source fluctuations. The conical fields of view 73a, 73b for each of the fibers 69c,d, respectively, are positioned so that they have a substantially overlapping field of view of the same spatial area of radiation being emitted from the radiation source 58. This ensures that both ends 71d,e of the fibers 69c,d see the same radiation and compensate for both spatial and temporal variations in the properties of the radiation emanating from the source 58. Thus, if there are spatial variations in the property of the radiation, i.e., variations that occur across the area of radiation emitted from the source 58, this arrangement allows both fibers 69c,d to see the same variation, thereby allowing for compensation of such variations.

If the area of the fibers 69 is large because a bundle is used, then the fibers that are used to collect radiation for the reference detector 63 are in the signal bundle, and may be evenly distributed within the bundle or at the center of the bundle if only a few fibers are used. For example, in the version illustrated in Figure 2b, two sets of fibers 69g,h are spaced apart and distributed so that the radiation seen by each set is from substantially the same sized area of the radiation source 58, which may be a portion or the entire field of radiation emanating from the source 58. For example, the fibers 69g that transmit radiation from the source 58 to the reference detector 63 may be interspersed with the fibers 69h that transmit radiation from the source 58 to the chamber 28 so the conical fields of view 73c,d, respectively, cover an entire radiation transmitting portion of the radiation source. The larger area of the source 58 covered by a plurality of fibers having overlapping field of views 73c,d reduces the spatial variability of the radiation and allows averaging of the radiation signal emanating from a larger portion or area of the radiation source 58. It may also be desirable for both sets of fibers 69g,h to cover the same area of the radiation source 58 so that the same source fluctuations are seen, and this is accomplished by interspersing the fibers to provide overlapping fields of view covering the same region.

In the version illustrated in Figure 2c, a lens 77 (or lens assembly which is not shown) is used to focus radiation from the radiation source 58 onto an end 73 of the fibers 69. The lens 77 can match the field of view of the fibers 69 thereby allowing more radiation to be incident on the fibers and is particularly useful when the area of the end 73 of the fibers 69 is much smaller than the radiation emitting area of the radiation source 58. Again, because a larger area of radiation from the source 58 is concentrated and focused onto the end of the fibers 69, there is provided enhanced averaging of the spatial variations of the radiation emanating from the radiation source 58, thereby further reducing the effect of such variations. Alternatively, the lens 77 can be used to couple light from a selected region of the radiation source if that region is more stable.

Figure 2d illustrates simply that the radiation source 58 may also be the plasma in the chamber 28 that emits radiation, and when such a source is used the fibers 69e,f are positioned to receive the reflected radiation 64 from the substrate 20, as well as reference radiation 62 which is not reflected from the substrate 20 and originates directly from the plasma in the chamber 28. For example, the fibers 69e are positioned to transmit reflected radiation 64 from the substrate 20 directly to the sample detector 62; and the fibers 69f transmit radiation from a portion of the plasma which is not reflected from the substrate -- by being pointed toward another region such as a wall 50 in the chamber 28 — to the reference detector 63a. In another embodiment, the reference detector 63b also receives radiation 62b originating from the plasma but which is viewed from the side of the plasma (which does not interact with the substrate) and not from the top of the plasma (which does interact with the substrate). In these versions, the fluctuations in plasma intensity that arise from species emission charges, plasma brightness variations, or other such variations, are needed to compensate for the fluctuation and are detected by collecting plasma light which is not reflected off the substrate 20.

In these versions, the fibers 69 may preferably lead directly to the reference detector 63 so that the radiation pathway travels along the fiber to the reference detector 63 substantially without ending or breaking in the process chamber 28 and without ending or breaking for moving parts (although the radiation may pass through a nonmoving filter). This direct connection via the fiber 69 is less prone to collect noise from outside light sources and easy to configure in different types of apparatuses. Thus, the directly connected fibers 69 are advantageous over other light transmitting systems employing either moving parts (such as monochromators) or more complex parts (such as conventional beam splitters). However, the fibers 69 may be replaced by a beam splitter (not shown) such as a semipermeable mirror to transmit a reference signal to a detector 63. While the beam splitter will work, it is generally preferred to use fibers 69 to transmit radiation originating from the radiation source 58 directly to the detector 63. This is because conventional beam splitters are more costly and complex and require additional mounting and positioning means. Also, although a conventional beam splitter works well with a well-defined and collimated beam with a consistent profile, if the intensity of the radiation from the source 58 varies spatially, the portion of the beam which acts as a reference must be selected by additional optics and such means.

Optionally, a lens 66 (or assembly of lenses) is used to focus radiation emitted by the radiation source 58 onto the substrate 20 and/or to focus radiation 64 at least partially reflected back from the substrate 20 onto the sensor of the detector 62. For example, for a radiation source 58 comprising a Hg-discharge lamp located outside the chamber 28, as shown in Figure 1, a plurality of convex lenses 68a, 68b can be used to focus radiation from the lamp through the window 61 and onto a beam spot 70 on the substrate 20.

The area of the beam spot 70 should be sufficiently large to provide an accurate measurement of the surface topography of the substrate 20. The lenses 68a, 68b can also be used to focus reflected radiation 64 back onto the sensor of the radiation detector 62. The configuration in which radiation strikes the substrate at an incident angle of about 90 °, as shown in Figure 1, is preferred for interferometry; however, as is known in the art, other incident angles can also be used and the apparatus 26 for receiving the reflected radiation positioned accordingly.

Optionally, a positioner 72 is used to scan the incident radiation 60 across the substrate surface to locate a suitable portion of the substrate 20 on which to "park" the beam spot 70. The positioner 72 comprises one or more primary mirrors 74 that rotate at small angles to deflect radiation from the radiation source 58 onto different positions of the substrate surface (as shown). Alternatively, the mirrors 74 can also direct radiation emitted from a plasma emission and at least partially reflected off the substrate 20 back onto the radiation detector 62. Additional secondary mirrors (not shown) can be used to intercept and focus reflected radiation back on the radiation detector 62. The positioner 72 can also be used to scan the radiation in a raster pattern across the substrate 20. In this version, the positioner 72 further comprises a movable stage (not shown) upon which the radiation source 58, lens assembly 66, and radiation detector 62 are mounted. The movable stage can be moved through set intervals by a drive mechanism, such as a stepper motor, that scans or otherwise moves the beam spot 70 across the substrate 20.

Radiation having a plurality of wavelengths, such as polychromatic light from a lamp or a plasma emission spectra, can be reduced to a single or narrow band of wavelengths by placing a monochromator or filter 75, 76 in the path of the radiation detector 63 and/or the incident or reflected radiation 60, 64. The monochromator or filter 76 may be located in the lens assembly 66 but can also be located at other positions in the chamber 28, for example, in the chamber window 61, in front of the radiation detectors 62, 63 or in front of the radiation source 58. A suitable filter comprises a stack of thin films on a transparent support that selectively transmits radiation having the desired wavelength or a lens made from a material that selectively passes radiation having the desired wavelength. The monochromator 75, 76 can also comprise a diffraction grating having a diffraction spacing that scatters radiation having undesirable wavelengths and allow radiation having the desired wavelength to pass through. Although usable in some embodiments, rotating disk monochromators and varying wavelength filters are not preferred because of their greater complexity. For enhanced simplicity and reliability, the monochromator or filter preferably does not have moving parts. Other suitable filtering means, for example, attenuation of radiation through a long pathlength in a partially absorbing material, or selective filtering by the radiation detectors 62, 63 to generate an electrical signal based only the portion radiation having the desired wavelength, can also be used. Since the intensity of the source radiation at different wavelengths can vary independently, it is usually desirable to select for the same wavelength for both the sample and reference radiation.

Properties of the radiation, such as intensity, phase, or wavelength are measured by the radiation detectors 62, 63 and converted to electrical signals. The detectors 62, 63 are capable of detecting a first property of a reflected radiation emanating from the chamber 28 and a second property of the radiation originating from the radiation source 58. The first and second properties can be different properties or the same property. The electrical signals from the detectors 62 (the sample signal) and 63 (the reference signal) are transmitted to a signal analyzer 130 which electrically manipulates or operates on the electrical signals to reduce the effect of the fluctuations in the characteristics of the radiation as it originates from the radiation source 58. For clarity, the signal analyzer 130 and signal monitoring software 126 are shown as separate components in Figure 1; however, these components can be the same thing and are usually part of the computer 114.

In a first embodiment of the invention, the signal analyzer 130 normalizes a first property of the reflected radiation relative to a second property of the radiation originating from the radiation source 58. By "normalizing" it is meant that the measured first property of the sample signal is modified by the measured second property of the reference signal to derive a normalized signal that takes into account or has compensated for fluctuations of the source radiation. Thus, normalizing could involve modifying the sample and reference signals by subtraction of one signal from the other, division, or other types of mathematical operations or comparisons, and combinations of these methods. A particular signal normalizing procedure that is found to be especially advantageous for use in semiconductor process chambers, especially plasma chambers, is obtaining a normalized sample signal by dividing the sample signal with the reference signal. The division process of normalization is preferred because it does not require gain matching in the sample and reference channels. In a typical normalization step, the signal analyzer 130 mathematically operates on the sample and reference signals to determine a normalized sample signal by the expression:

$$X_n = X_t \, / \, Y_t \; ;$$

where $X_n$ is the normalized sample signal, $X_t$ is the original sample signal at time t, and $Y_t$ is the reference signal also the at same time t. Variations in $X_t$ due to the source will be canceled by the source reference Yt.

Even more accurate and less noisy signals can be obtained by accounting for other effects which create differences between the sample and reference signals. Specifically, if the processing environment has radiation which is not from the source (e.g., ambient light), this will add to the sample signal but not to the reference signal. In addition, radiation detectors may have dark current, yielding a nonzero signal when no light is present. Since stray light in the reference channel can be controlled, and detector dark current can be minimized with appropriate choice of detector type and offset electronics, background light in the sample signal channel is typically the dominant factor requiring compensation. During processing in a process chamber 28, where an external radiation source is used and the corresponding reflected radiation is used to monitor events in the process chamber, radiation emitted by the plasma is usually the primary source of background radiation. Thus a correction for background radiation can also be applied by the signal analyzer 130 to further reduce the effect of fluctuations in the source and background radiation. The signal analyzer 130 mathematically operates on the sample signals to determine a sample signal corrected for background fluctuations, as shown in equations (1) and (4) below.

In a preferred method, the signal analyzer 130 mathematically operates on the sample and reference signals to determine a normalized sample signal corrected for both source fluctuations and ambient background, using the expression:

$$X_{nt} = X_t / \{Y_0 + C(Y_t - Y_0)\} \qquad (1)$$

where C is the correction factor, $Y_0$ is the reference signal at time 0, $X_t$ is the sample signal at time t, and $Y_t$ is the reference signal at time t. The correction factor C is determined by:

$$C = \{(X_t - X_1) / X_1\} \{Y_0 / (Y_t - Y_0)\} \qquad (2)$$

In a process where background radiation is generated (such as plasma processing), the sample signal data point obtained at a time 1 (i.e., at a sufficiently early time when the reflected source signal has not significantly changed from its initial state) can be expressed as:

$$X_1 = X_0 + B_1 \qquad (3)$$

Assuming the background radiation is constant, $B_t = B_1$ for all measurements, i.e., t = 2, 3, etc. Since the detector gain is constant for small and large signals, the substitution $(X_t - X_1) / (Y_t - Y_0) \sim X_0 / Y_0$ can be made, yielding:

$$C = X_0 / X_1 \qquad (4)$$

The system analyzer 130 can use the expression of equation 4 to automatically calculate the correction factor C and apply the correction factor to calculate a normalized sample signal using equation 1. In an alternative embodiment, equation 2 rather than equation 4 can be used to calculate the correction factor.

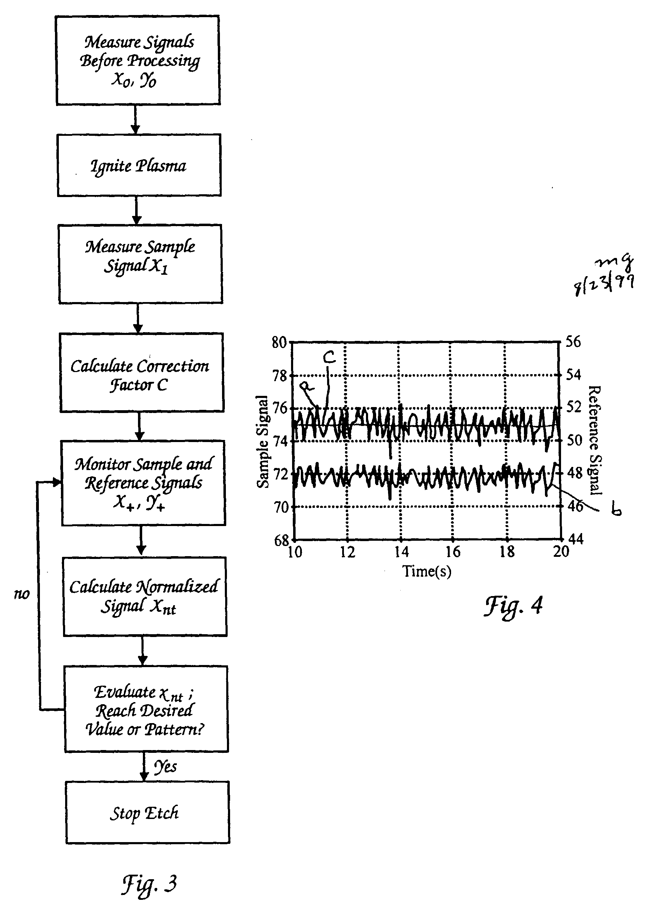

An embodiment of the invention using correction for background light in an etching process may be better understood with reference to the flowchart in Figure 3. Initial measurements of the sample and reference signals are acquired. Then the plasma is ignited. After the plasma has stabilized, but before significant etching has taken place, a sample signal, $X_1$, is acquired and used to calculate the correction factor C according to equation 4. The etching process is monitored as a function of time by measuring the sample signal, $X_t$, and the reference signal, $Y_t$. The signal analyzer 130 inputs these signals and the correction factor in equation 1 to calculate the normalized sample signal $X_{nt}$. In this manner, accurate and reliable etch measurements are achieved even in the presence of background radiation and source lamp variations. The normalized sample signal is continuously monitored by the signal analyzer 130 and/or the computer 114 until the desired etch depth (or, alternatively viewed, layer thickness) has been obtained. This can be either by obtaining a desired value or desired pattern such as an interference pattern or characteristic endpoint waveform. At this point, the signal analyzer 130 or the computer 114 relays a signal to the process controller and the etch process is stopped. Thus etched features having the desired dimensions or a thickness of a layer deposited on the substrate or in the substrate itself are accurately and reliably obtained. The process may be monitored and controlled by a human through monitor interface 118 or the process may be entirely controlled via the automated system 110.

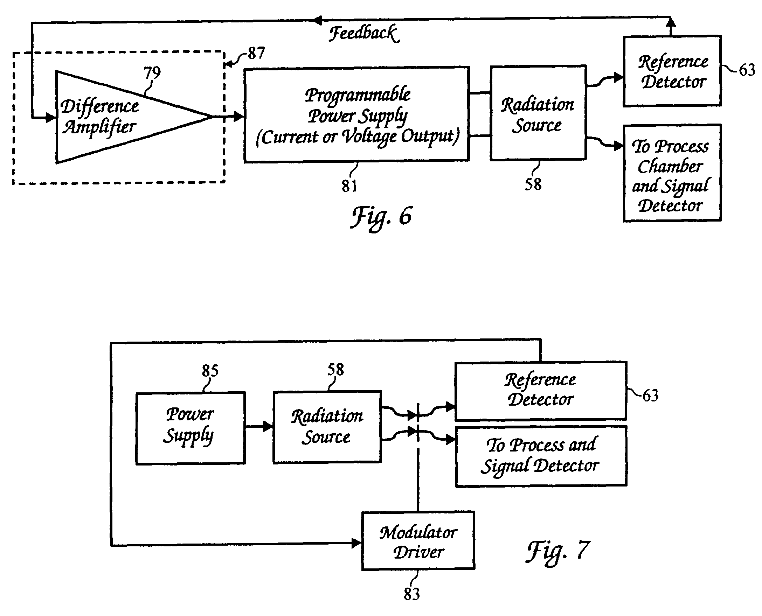

In another version of the invention, the instability of the radiation source 58 is addressed by monitoring the radiation emitted by the source and using a feedback controller 87 comprising a conventional closed loop feedback circuit to control power to the radiation source 58 to regulate any fluctuations or instabilities of its radiation output. For example, Figures 6 and 7 show two methods to achieve constant light output using the feedback control method instead of the normalizing mode. Both methods use a reference detector 63 which senses a radiation output or other property from the radiation source 58, either directly or using a beam splitter or fibers 69 as described herein. In the version illustrated in Figure 6, a reference detector 63 sends a reference signal as feedback to a difference (error) amplifier 79 to control a programmable power supply 81 which powers the radiation source 58. When the reference signal deviates from a desired or constant level, an error signal generated by the feedback controller 87 instructs the power supply 81 to correct in the direction of reducing the error, to try to maintain the source radiation at a controlled and flat output level.

Figure 7 illustrates another version of the feedback controller 87, in which a reference detector 63 is used to control a radiation modulator 83 in the path of the radiation output transmitted to the process chamber 28. The radiation modulator 83 is a device that modifies or otherwise changes a property of the radiation passing through it. For example, a radiation intensity may be controlled by a radiation modulator 83 comprising a low mass mechanical shutter, mirror, or variable density screen as means for partially attenuating the radiation that moves to block, filter, or otherwise reduce the radiation intensity level from the radiation source 58. The radiation modulator 83 may also comprise an electro-optical or acoustic-optical transducer that may operate at higher frequencies. Other radiation modulators 83 may also be used which incorporate other elements, such as lenses and diffraction gratings or moving mirrors.

While the feedback controller 87 may be effective in reducing source fluctuations, it may have some disadvantages over the normalizing method. For example, the feedback method may require limiting the nominal radiation output to a lower level than maximum attainable level to enable proper control of source fluctuations. Also, the normalizing method may be preferred for applications requiring as much radiation output as possible to enhance the signal to noise ratio. Other considerations relate to the flexibility and dynamic range that is desirable. For example, as a radiation source 58, such as a lamp, ages its output decreases over time, the feedback method can only correct over a limited range while the normalizing method can correct over the entire range. In addition, the normalizing method may be less limiting because it may also be used to compensate for background radiation or other effects.

Controller and Computer System

The chamber and endpoint detection system 56 is operated by a chamber controller 110 that executes software of a computer-readable program 112 of a computer system comprising a central processor unit (CPU) 114, such as for example a 68040 microprocessor, commercially available from Synergy Microsystems, California, or a Pentium Processor commercially available from Intel Corporation, Santa Clara, California, that is coupled to a memory 116 and peripheral computer components. The memory 116 comprises a computer-readable medium having a computer-readable program embodied therein. Preferably, the memory 116 is a hard disk drive 122, but the memory can also be other kinds of memory, such as random access memory (not shown). In addition to memory 116, controller 110 can include a floppy disk drive 122 and a card rack. The interface between an operator and the controller 110 can be, for example, via a monitor 118 and a light pen 120, as shown in Figure 1. The light pen 120 detects light emitted by the monitor 118 with a light sensor in the tip of the light pen 120. To select a particular screen or function, the operator touches a designated area of a screen on the monitor 118 and pushes the button on the light pen 120. Typically, the area touched changes color, or a new menu is displayed, confirming communication between the user and the controller 110. In the preferred embodiment, two monitors 118 and light pens 120 are used, one mounted in a clean room for the operators and the other behind the wall for service technicians. Both monitors 118 simultaneously display the same information, but only one light pen 120 is enabled.

Other computer-readable programs such as those stored on other memory including, for example, a floppy disk or other computer program product inserted in a disk drive 122 or other appropriate drive, may also be used to operate the controller 110. The computer system card rack contains a single-board computer, analog and digital input/output boards, interface boards, and stepper motor controller boards. Various components of the apparatus 26 conform to the Versa Modular European (VME) standard, which defines board, card cage, and connector dimensions and types. The VME standard also defines the bus structure having a 16-bit data bus and 24-bit address bus.

The computer program 112 generally comprises process control software 124 comprising a set of instructions of program code to operate the chamber 28 and its components, signal monitoring software 126, safety systems software, and other control software. The computer-readable program can be written in any conventional computer-readable programming language, such as for example, assembly language, C, C++, Pascal, or Fortran. Suitable program code is entered into a single file, or multiple files, using a conventional text editor and stored or embodied in the computer-usable medium of the memory 116 of the computer system. If the entered code text is in a high level language, the code is compiled, and the resultant compiler code is then linked with an object code of precompiled library routines. To execute the linked, compiled object code, the user invokes the object code, causing the CPU 114 to read and execute the code to perform the tasks identified in the program.

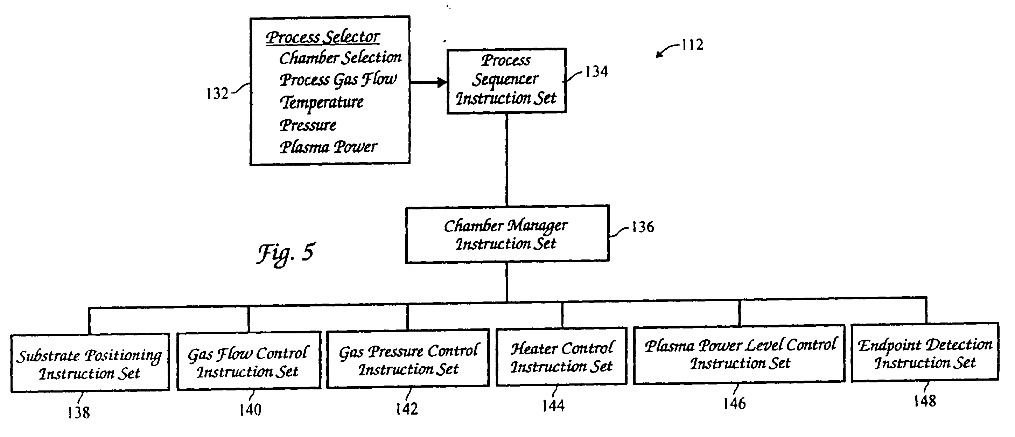

The processes for etching the substrate 20 and optionally cleaning the chamber 28 are implemented by the process control software 124 and is executed by the process controller 128. The process control software 124 includes sets of instructions that dictate the timing, gas compositions, gas flow rates, chamber pressure, chamber temperature, RF power levels, support position, heater temperature, and other parameters of a particular process. Figure 5 is an illustrative block diagram of the hierarchical control structure of the process control software 124, according to a specific embodiment. Using a light pen interface, a user enters a process set number and process chamber number into a process selector instruction set 132 in response to menus or screens displayed on the CRT terminal. The process sets are predetermined groups of process parameters necessary to carry out specified processes, and which are identified by predefined set numbers. Process selector instruction set 132 identifies (i) a desired process chamber 28, and (ii) the desired set of process parameters needed to operate the process chamber for performing the desired process. The process parameters for performing a specific process relate to process conditions, without limitations, such as for example, gas composition, gas flow rates, temperature, pressure, plasma conditions such as RF power levels (and in addition, microwave generator power levels for embodiments equipped with remote microwave plasma systems), cooling gas pressure and chamber wall temperature. Process selector instruction set 132 controls what type of process (etching, deposition, wafer cleaning, chamber cleaning, chamber gettering, reflowing) is performed at a certain time in chamber. In some embodiments, there may be more than one process selector instruction set 132. The process parameters are provided to the user in the form of a recipe and may be entered utilizing the light pen and monitor interface.

A process sequencer instruction set 134 comprises program code for accepting the identified process chamber 28 and set of process parameters from the process selector instruction set 132, and for controlling operation of the various process chambers. Multiple users can enter process set numbers and process chamber numbers or a single user can enter multiple process set numbers and process chamber numbers, so the sequencer instruction set 134 operates to schedule the selected processes in the desired sequence. Preferably the sequencer instruction set 134 includes program code to perform the steps of (i) monitoring the operation of the process chambers 28 to determine if the chambers are being used, (ii) determining what processes are being carried out in the chambers being used, and (iii) executing the desired process based on availability of a process chamber 28 and the type of process to be carried out. Conventional methods of monitoring the process chambers 28 can be used, such as polling. When scheduling which process is to be executed, sequencer instruction set 134 can be designed to take into consideration the present condition of the process chamber 28 being used in comparison with the desired process conditions for a selected process, or the "age" of each particular user-entered request, or any other relevant factor a system programmer desires to include for determining scheduling priorities.

Once the sequencer instruction set 134 determines which process chamber 28 and process set combination is going to be executed next, the sequencer instruction set 134 initiates execution of the process set by passing the particular process set parameters to a chamber manager instruction set 136 that controls multiple processing tasks in a process chamber 28 according to the process set determined by the sequencer instruction set 134. For example, the chamber manager instruction set 136 comprises program code for controlling etch or deposition operations in the process chamber 28. Chamber manager instruction set 136 also controls execution of various chamber component instruction sets that control operation of the chamber components necessary to carry out the selected process set. Examples of chamber component instruction sets are substrate positioning instruction set, gas flow control instruction set 140, gas pressure control instruction set 142, optional heater control instruction set 144 for chambers equipped with a heater in the support, and plasma control instruction set 146. Depending on the specific configuration of the chamber 28, some embodiments include all of the above instruction sets or instruction set, while other embodiments may include only some of the instruction sets. Those having ordinary skill in the art would readily recognize that other chamber control instruction sets can be included depending on what processes are to be performed in the process chamber 28.

In operation, the chamber manager instruction set 136 selectively schedules or calls the process component instruction sets in accordance with the particular process set being executed. The chamber manager instruction set 136 schedules the process component instruction sets much like the sequencer instruction set schedules which process chamber 28 and process set are to be executed next. Typically, chamber manager instruction set 136 includes steps of monitoring the various chamber components, determining which components need to be operated based on the process parameters for the process set to be executed, and initiating execution of a chamber component instruction set responsive to the monitoring and determining steps.

Operation of chamber component instruction sets will now be described. The substrate positioning instruction set 138 comprises program code for controlling chamber components that are used to load the substrate 20 onto the support 32 and optionally, to lift the substrate 20 to a desired height in the chamber 28 to control the spacing between the substrate 20 and the gas outlets 38 of the gas delivery system 34.

The process gas control instruction set 140 has program code for controlling the flow rates of different constituents of the process gas. The process gas control instruction set 140 controls the open/close position of the safety shut-off valves, and also ramps up/down the mass flow controllers to obtain the desired gas flow rate. The process gas control instruction set 140 is invoked by the chamber manager instruction set 136, as are all chamber component instruction sets, and receives process parameters related to the desired gas flow rates from the chamber manager 136. Typically, the process gas control instruction set 140 operates by opening the gas supply, and repeatedly (i) reading the necessary mass flow controllers, (ii) comparing the readings to the desired flow rates received from the chamber manager instruction set 136, and (iii) adjusting the flow rates of the gas supply lines as necessary. Furthermore, process gas control instruction set 140 includes steps for monitoring the gas flow rates for unsafe rates and activating the safety shut-off valves when an unsafe condition is detected. Process gas control instruction set 140 also controls the gas composition and flow rates for clean gases as well as for etching of deposition gases, depending on the desired process (etching, clean or deposition or other) that is selected. Alternative embodiments could have more than one process gas control instruction set 140, each instruction set controlling a specific type of process or specific set of gas flow controllers.

In some processes, an inert gas such as nitrogen or argon is flowed into chamber 28 to stabilize the pressure in the chamber before reactive process gases are introduced. For these processes, the process gas control instruction set 140 is programmed to include steps for flowing the inert gas into chamber 28 for an amount of time necessary to stabilize the pressure in the chamber, and then the steps described above would be carried out. Additionally, when a process gas is to be vaporized from a liquid precursor, for example in the deposition of TEOS-derived glass, process gas control instruction set 140 is written to include steps for bubbling a delivery gas, such as helium, through the liquid precursor in a bubbler assembly, or for introducing a carrier gas, such as helium, to a liquid injection system. When a bubbler is used for this type of process, the process gas control instruction set 140 regulates the flow of the delivery gas, the pressure in the bubbler, and the bubbler temperature in order to obtain the desired process gas flow rates. As discussed above, the desired process gas flow rates are transferred to the process gas control instruction set 140 as process parameters. Furthermore, the process gas control instruction set 140 includes steps for obtaining the necessary delivery gas flow rate, bubbler pressure, and bubbler temperature for the desired process gas flow rate by accessing a stored table containing the necessary values for a given process gas flow rate. Once the necessary values are obtained, the delivery gas flow rate, bubbler pressure, and bubbler temperature are monitored, compared with the necessary values, and adjusted accordingly.

The pressure control instruction set 142 comprises program code for controlling the pressure in the chamber 28 by regulating the aperture size of the throttle valve 44 in the exhaust system 42 of the chamber. The aperture size of the throttle valve 44 is set to control the chamber pressure at a desired level in relation to the total process gas flow, the size of the chamber 28, and the pumping set-point pressure for the exhaust system 42. When the pressure control instruction set 142 is invoked, the desired or target pressure level is received as a parameter from the chamber manager instruction set 136. The pressure control instruction set 142 measures the pressure in the chamber 28 by reading one or more conventional pressure manometers connected to the chamber 28, compares the measure value(s) with the target pressure, obtains PID (proportional, integral, and differential) values corresponding to the target pressure from a stored pressure table, and adjusts the throttle valve 44 according to the PID values obtained from the pressure table. Alternatively, the pressure control instruction set 142 can be written to open or close the throttle valve 44 to a particular aperture size to regulate the pumping capacity in chamber 28 to the desired level.

Optionally, the heater control instruction set 144 comprises program code for controlling the temperature of an optional heater element (not shown) used to resistively heat the support 32 and substrate 20. The heater control instruction set 144 is also invoked by the chamber manager instruction set 136 and receives a target, set-point, or temperature parameter. The heater control instruction set 144 measures the temperature by measuring voltage output of a thermocouple located in the support, comparing the measured temperature with the set-point temperature, and increasing or decreasing current applied to the heating unit to obtain the set-point temperature. The temperature is obtained from the measured voltage by looking up the corresponding temperature in a stored conversion table or by calculating the temperature using a fourth-order polynomial. When an embedded loop is used to heat support, the heater control instruction set 144 gradually controls a ramp up/down of current applied to the loop. Additionally, a built-in, fail-safe mode can be included to detect process safety compliance and to shut down operation of the heating unit if the process chamber 28 is not properly set up.

The plasma control instruction set 146 comprises program code for setting low and high-frequency RF power levels applied to the process electrodes 50, 52 in the chamber 28. Like the previously described chamber component instruction sets, the plasma control instruction set 146 is invoked by the chamber manager instruction set 136. For embodiments including remote plasma generator 46, the plasma control instruction set 146 would also include program code for controlling a remote plasma generator (not shown).

The endpoint detection instruction set 148 comprises program code that obtains the sample and reference signals from the signal analyzer and normalizes the property of the reflected radiation relative to the property of the radiation originating from the radiation source 58, the properties comprising one or more of an intensity, phase or wavelength. The normalization method, i.e., dividing, subtracting, or multiplying the two signal properties is pre-programmed into the computer software. In addition, the compensation factor for determining background radiation is also written as program code. The endpoint detection instruction set 148 further comprises program code for performing other functions, such as detecting the endpoint of the process being performed on the substrate 20 based on a pre-determined method of evaluating the normalized sample signal and sending instructions to the chamber manager instruction set 136 or other instruction sets to change the process or other chamber conditions.

<u>EXAMPLE</u>

The following example illustrates the operation and superior results obtained through use of the present invention. The apparatus used is essentially that depicted in Figure 1, and is a Model Si ETCH DPS available from Applied Materials, Santa Clara, California. A blank silicon wafer was loaded into the process chamber. The source mercury discharge lamp and the sample and reference detectors were turned on. The source mercury discharge lamp was a Model CPG-1, available from Jelight Co. of Irvine, California; and the sample and reference detectors (photomultipliers, Hamamatsu Model R728). Either optical bandpass filters or monochromators were used to select the mercury emission at about 254 nm. The radiation transmitting fiber was used to transmit light from the lamp to the reference detector and the process chamber, and from the process chamber to the sample detector. A sample signal ($X_0$) and reference signal ($Y_0$) were acquired before igniting a plasma.

A plasma was ignited at 600W power for a process gas comprising $SF_6$ introduced into the chamber. Two detectors were used to simultaneously acquire the reference (Y) and sample (X) signals. The signals were transmitted to the signal analyzing computer, namely the Centura Endpoint Computer, available from Applied Materials, Santa Clara, California. The computer calculated the correction factor from the expression $C = X_0 / X_1$, and calculated the corrected sample signal using the expression $X_{nt} = X_t / \{Y_0 + C(Y_t - Y_0)\}$. A plot of the signals from 10 to 20 seconds is shown in Figure 4, where trace a is the sample signal, trace b is the reference signal and trace c is the corrected signal.

In this example, the apparatus and methods of the present invention (without background correction) achieved a 10 fold (1000%) improvement in the signal-to-noise ratio of the sample signal. The apparatus and methods of the present invention (with background correction, signal c) achieved a 40 fold (4000%) improvement in the signal-to-noise ratio of the sample signal.

Since a blank wafer was used in this experiment, the signal c in Figure 4 is featureless and smooth. In actual use, a wafer being etched would produce a time varying signal which, with the present invention, can be of small amplitude and still be readily detectable.

The present invention has been illustrated by way of an exemplary plasma etching process, however, other versions are possible. For example, the monitoring process and apparatus can be used for other processes and in other chambers as would be apparent to one of ordinary skill, including without limitation, sputtering chambers, ion implantation chambers and other deposition chambers.

**Claims**

1.  A substrate processing apparatus comprising:

    (a) a chamber comprising a radiation source;
    (b) one or more detectors to detect a first radiation from the chamber, and a second radiation from the radiation source; and
    (c) a signal analyzer to normalize a property of the first radiation relative to a property of the second radiation.

2.  An apparatus according to claim 1 comprising a first detector to detect a first radiation that is reflected in the chamber and generate a sample signal; and a second detector to detect a second radiation from the radiation source and generate a reference signal.

3.  An apparatus according to claim 1 wherein the signal analyzer normalizes the reference and sample signals relative to one another to determine a normalized signal.

4.  An apparatus according to claim 3 wherein the signal analyzer is adapted to determine a corrected sample signal by applying a correction factor to the normalized signal.

5.  An apparatus according to any of the preceding claims further comprising a radiation pathway capable of transmitting the second radiation from the radiation source to the second detector.

6.  A method for monitoring processing of a substrate in a chamber, the method comprising the steps of:

    (a) providing radiation in the chamber, detecting the radiation after it interacts with the substrate being processed, and generating a sample signal;
    (b) detecting a reference radiation that does not interact with the substrate and generating an reference signal; and
    (c) normalizing the sample signal relative to the reference signal.

7.  A method according to claim 6 wherein step (c) comprises the step of determining a ratio of the reference signal and the sample signal, or subtracting the reference signal from the sample signal.

8.  A method according to claim 7 further comprising the step of correcting for a background radiation by applying a correction factor to the sample signal to determine a corrected sample signal.

9. A substrate processing apparatus comprising:

(a) a chamber comprising a radiation source;
(b) a detector to detect a property of a radiation from a radiation source; and
(c) a feedback controller to regulate a power level of the radiation source in relation to the detected property of the radiation or a radiation modulator in a path of a radiation being transmitted from the radiation source to the chamber, whereby the radiation modulator may receive a signal from the radiation source and control a property of the radiation in relation to the reference signal.

10. An apparatus according to claim 9 wherein the radiation modulator comprises an electro-optical or acoustic-optical transducer.

Fig. 1

Fig. 2a

Fig. 2b

Fig. 2c

Fig. 2d

Measure Signals
Before Processing
$X_0$, $Y_0$

Ignite Plasma

Measure Sample
Signal $X_1$

Calculate Correction
Factor C

Monitor Sample and
Reference Signals
$X_+$, $Y_+$

Calculate Normalized
Signal $X_{nt}$

no

Evaluate $X_{nt}$;
Reach Desired
Value or Pattern?

Yes

Stop Etch

Fig. 3

Fig. 4

18

EP 1 079 415 A1

Process Selector
Chamber Selection
Process Gas Flow
Temperature
Pressure
Plasma Power

132

Process Sequencer Instruction Set — 134

— 112

Fig. 5

Chamber Manager Instruction Set — 136

| Substrate Positioning Instruction Set | Gas Flow Control Instruction Set | Gas Pressure Control Instruction Set | Heater Control Instruction Set | Plasma Power Level Control Instruction Set | Endpoint Detection Instruction Set |
|---|---|---|---|---|---|
| 138 | 140 | 142 | 144 | 146 | 148 |

Feedback

Difference
Amplifier
79

87

Programmable
Power Supply
(Current or Voltage Output)
81

Radiation
Source
58

Reference
Detector
63

To Process
Chamber
and Signal
Detector

*Fig. 6*

Power
Supply
85

Radiation
Source
58

Reference
Detector
63

To Process and
Signal Detector

Modulator
Driver
83

*Fig. 7*

EP 1 079 415 A1

European Patent
Office

**EUROPEAN SEARCH REPORT**

Application Number

EP 00 11 7642

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 289 188 A (HITACHI) 15 September 1981 (1981-09-15) * claim 1; figure 3 * --- | 1,6 | H01J37/32 G01B11/06 H01L21/00 |
| X | US 4 491 499 A (ATT) 1 January 1985 (1985-01-01) * claim 1 * --- | 1,6 | |
| X | EP 0 841 682 A (TOKYO ELECTRON) 13 May 1998 (1998-05-13) * page 3, line 33 - line 45 * --- | 1,6 | |
| X | F.G.BÖBEL ET AL.: "In situ film-thickness and temperature monitor" SOLID STATE TECHNOLOGY, vol. 37, no. 8, 1 August 1994 (1994-08-01), pages 55-59, XP000461428 Tulsa, OK (US) * page 56, line 13 - line 14; figure 3 * --- | 9 | |
| A | US 4 927 785 A (PHILIPS) 22 May 1990 (1990-05-22) * column 4, line 21 - line 26; figure 2 * --- | 1,6,9 | TECHNICAL FIELDS SEARCHED (Int.Cl.7) H01J G01B |
| A | US 4 183 672 A (UTC) 15 January 1980 (1980-01-15) * column 5, line 57 - line 61; figures 2,3 * --- | 9 | |
| A | US 5 565 114 A (TOKYO ELECTRON) 15 October 1996 (1996-10-15) * claim 1; figure 14 * --- | | |
| A | US 5 405 488 A (VLSI) 11 April 1995 (1995-04-11) * claim 1; figure 3 * --- | | |

-/--

The present search report has been drawn up for all claims

| Place of search | Date of completion of the search | Examiner |
|---|---|---|
| MUNICH | 30 November 2000 | Mielke, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent
Office

## EUROPEAN SEARCH REPORT

Application Number

EP 00 11 7642

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 5 738 756 A (LAM RESEARCH) 14 April 1998 (1998-04-14) * claim 1 * | | |
| A | WO 94 25977 A (APPLIED MATERIALS) 10 November 1994 (1994-11-10) * claim 1 * | | |
| A | US 5 208 644 A (XINIX) 4 May 1993 (1993-05-04) * claim 1; figure 1 * | | |
| A | US 5 362 969 A (LUXTRON) 8 November 1994 (1994-11-08) * figures 2A,B * | | |

TECHNICAL FIELDS
SEARCHED    (Int.Cl.7)

The present search report has been drawn up for all claims

| Place of search | Date of completion of the search | Examiner |
|---|---|---|
| MUNICH | 30 November 2000 | Mielke, W |

**ANNEX TO THE EUROPEAN SEARCH REPORT
ON EUROPEAN PATENT APPLICATION NO.**                EP 00 11 7642

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2000

| Patent document cited in search report | | Publication date | Patent family member(s) | | Publication date |
|---|---|---|---|---|---|
| US 4289188 | A | 15-09-1981 | JP | 55157233 A | 06-12-1980 |
| | | | JP | 57012529 B | 11-03-1982 |
| | | | DE | 3019583 A | 11-12-1980 |
| | | | GB | 2050952 A,B | 14-01-1981 |
| US 4491499 | A | 01-01-1985 | NONE | | |
| EP 841682 | A | 13-05-1998 | JP | 10189552 A | 21-07-1998 |
| | | | US | 5928532 A | 27-07-1999 |
| US 4927785 | A | 22-05-1990 | FR | 2616269 A | 09-12-1988 |
| | | | DE | 3851370 D | 13-10-1994 |
| | | | DE | 3851370 T | 20-04-1995 |
| | | | EP | 0294873 A | 14-12-1988 |
| | | | JP | 1015931 A | 19-01-1989 |
| | | | JP | 2716731 B | 18-02-1998 |
| US 4183672 | A | 15-01-1980 | CA | 1103497 A | 23-06-1981 |
| | | | DE | 2862112 D | 05-01-1983 |
| | | | EP | 0002428 A | 13-06-1979 |
| | | | JP | 1416974 C | 22-12-1987 |
| | | | JP | 54083852 A | 04-07-1979 |
| | | | JP | 62022084 B | 15-05-1987 |
| US 5565114 | A | 15-10-1996 | JP | 7066173 A | 10-03-1995 |
| | | | JP | 7073995 A | 17-03-1995 |
| | | | JP | 7099184 A | 11-04-1995 |
| | | | JP | 7099185 A | 11-04-1995 |
| | | | US | 5728253 A | 17-03-1998 |
| | | | US | 5980767 A | 09-11-1999 |
| | | | JP | 6318572 A | 15-11-1994 |
| | | | US | 5739051 A | 14-04-1998 |
| US 5405488 | A | 11-04-1995 | WO | 9508186 A | 23-03-1995 |
| US 5738756 | A | 14-04-1998 | AU | 6342196 A | 05-02-1997 |
| | | | EP | 0836745 A | 22-04-1998 |
| | | | JP | 11509685 T | 24-08-1999 |
| | | | WO | 9702593 A | 23-01-1997 |
| WO 9425977 | A | 10-11-1994 | EP | 0662241 A | 12-07-1995 |
| | | | US | 5552016 A | 03-09-1996 |
| US 5208644 | A | 04-05-1993 | US | 5414504 A | 09-05-1995 |
| | | | WO | 9118283 A | 28-11-1991 |
| | | | US | 5946082 A | 31-08-1999 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 00 11 7642

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2000

| Patent document cited in search report | Publication date | Patent family member(s) | Publication date |
|---|---|---|---|
| US 5208644 A | | US 5786886 A | 28-07-1998 |
| US 5362969 A | 08-11-1994 | NONE | |

EPO FORM P0459